# EUROPEAN PATENT APPLICATION

(11) **EP 4 826 449 A1**
(43) Date of publication of application: **21.10.2026**
(21) Application number: 24903596.5
(22) Date of filing: 05.12.2024
(51) Int. Cl.: G03F 7/038, C08G 59/18, G01T 1/20, G03F 7/004, G03F 7/20, G03F 7/095, G21K 4/00, H01L 21/027, H01L 23/29, H01L 23/31

(54) **PHOTOSENSITIVE RESIN COMPOSITION FILM, CURED PRODUCT, SCINTILLATOR PANEL USING SAME, AND SEMICONDUCTOR DEVICE**

(30) Priority: 13.12.2023 JP 2023209798; 28.08.2024 JP 2024146565
(71) Applicant: Toray Industries, Inc., Tokyo 103-8666 (JP)
(72) Inventor: NARIKIYO, Hayato, Otsu-shi, Shiga 520-8558 (JP); MORINAGA, Tomohiro, Otsu-shi, Shiga 520-8558 (JP); SEKIGUCHI, Hiroki, Otsu-shi, Shiga 520-8558 (JP)
(74) Representative: Kador & Partner Part mbB
(86) International application number: PCT/JP2024/043024
(87) International publication number: WO 2025/126939

(57) **Abstract**

Provided is a photosensitive resin composition film comprising (A) a resin, (B) an epoxy compound and/or an oxetane compound, and (C) a photocationic polymerization initiator, wherein:
a transmittance Tα (%) per unit film thickness at a wavelength of 405 nm of one surface and a transmittance Tβ (%) per unit film thickness at a wavelength of 405 nm of the other surface satisfy the following formula (1): $Tα > Tβ$ (1) and
a content C10 (% by mass) of the (C) photocationic polymerization initiator at a depth of 10%, relative to the thickness of the photosensitive resin composition film, from the surface on the side where the transmittance per unit film thickness at a wavelength of 405 nm is Tα (%), and a content C90 (% by mass) of the (C) photocationic polymerization initiator at a depth of 90% from the surface satisfy the following formula (2): $0.050 \leq C 10 / C 90 \leq 0.85$ (2)
The photosensitive resin composition film can form a pattern with a high aspect ratio.

## Description

### TECHNICAL FIELD

The present invention relates to a photosensitive resin composition film, a cured product, a method of manufacturing the same, and a scintillator panel and a semiconductor device using the same.

### BACKGROUND ART

In medical fields and industrial applications such as structure inspection and luggage inspection, digital radiation detectors such as flat panel detectors (FPDs) are used. In indirect conversion method FPDs, a scintillator panel is used to convert X-rays into visible light. A scintillator panel has a phosphor layer (scintillator layer) containing a phosphor such as gadolinium oxysulfide (GOS), and the phosphor emits light upon irradiation with X-rays. By converting the light emitted from the scintillator panel into electrical signals using a sensor (photoelectric conversion layer) having thin film transistors (TFTs) or charge-coupled devices (CCDs), X-ray information is converted into digital image information. However, scintillator panels have a problem in that light emitted from the radiation phosphor is scattered within the layer containing the phosphor (phosphor layer), reducing the sharpness of the resulting image.

Therefore, in order to reduce the influence of light scattering, a method has been proposed in which a phosphor is filled in a space partitioned by partition walls. Furthermore, as a technology to solve the problem of luminance reduction due to partition walls, a scintillator panel has been proposed (see, for example, Patent Document 1) which comprises a substrate, partition walls formed on the substrate, and a scintillator layer having a phosphor partitioned by the partition walls, wherein the partition walls contain one or more compounds (P) selected from the group consisting of polyimide, polyamide, polyamideimide, and polybenzoxazole.

On the other hand, when a scintillator panel is used for industrial applications such as food and electronic components, high-energy X-rays are continuously irradiated during inline inspection, so the luminance of the scintillator panel tends to decrease over time. To address this issue, a scintillator panel has been proposed (see, for example, Patent Document 2) which comprises a base material and a scintillator layer containing a phosphor, wherein the scintillator layer contains a binder resin having a π-conjugated structure composed of 7 or more atoms, the glass transition temperature of the binder resin is 30 to 430°C, and the film thickness of the scintillator layer is 50 to 800 µm.

### PRIOR ART DOCUMENTS

### PATENT DOCUMENTS

[Patent Document 1] WO 2021/200327
[Patent Document 2] WO 2022/024860

### SUMMARY OF THE INVENTION

### PROBLEMS TO BE SOLVED BY THE INVENTION

Although these technologies can improve the luminance of scintillator panels, particularly in industrial applications, increasing the thickness of the phosphor layer and thinning the partition walls are required to increase the amount of phosphor. Against this background, partition walls with a higher aspect ratio are required. Furthermore, in applications other than partition walls of scintillator panels, it is required to form high aspect ratio patterns using resin compositions. However, with conventionally known resin compositions, it has been difficult to form patterns such as partition walls with a high aspect ratio required from such backgrounds.

Accordingly, the present invention has been made in view of such problems of the prior art, and an object thereof is to provide a photosensitive resin composition film capable of forming a high aspect ratio pattern.

### SOLUTIONS TO THE PROBLEMS

[1] A photosensitive resin composition film comprising (A) a resin, (B) an epoxy compound and/or an oxetane compound, and (C) a photocationic polymerization initiator, wherein:
   a transmittance Tα (%) per unit film thickness at a wavelength of 405 nm of one surface and a transmittance Tβ (%) per unit film thickness at a wavelength of 405 nm of the other surface satisfy the following formula (1): $Tα > Tβ$ (1) and
   a content C10 (% by mass) of the (C) photocationic polymerization initiator at a depth of 10%, relative to the thickness of the photosensitive resin composition film, from the surface on the side where the transmittance per unit film thickness at a wavelength of 405 nm is Tα (%), and a content C90 (% by mass) of the (C) photocationic polymerization initiator at a depth of 90% from the surface satisfy the following formula (2): $0.050 \leq C 10 / C 90 \leq 0.85$ (2)
[2] The photosensitive resin composition film according to [1], comprising a first film consisting of a first photosensitive resin composition containing (A) a resin, (B) an epoxy compound and/or an oxetane compound, and (C) a photocationic polymerization initiator, and a second film consisting of a second photosensitive resin composition containing (A) a resin, (B) an epoxy compound and/or an oxetane compound, and (C) a photocationic polymerization initiator, wherein content of the (C) photocationic polymerization initiator in the first photosensitive resin composition and content of the (C) photocationic polymerization initiator in the second photosensitive resin composition are different.
[3] The photosensitive resin composition film according to [1] or [2], wherein the resin (A) contains polyimide, polyamide, polyamideimide and/or polybenzoxazole.
[4] A cured product obtained by curing a photosensitive resin composition containing (A) a resin, (B) an epoxy compound and/or an oxetane compound, and (C) a photocationic polymerization initiator, wherein:
   a transmittance T'α (%) per unit thickness at a wavelength of 405 nm of one surface and a transmittance T'β (%) per unit thickness at a wavelength of 405 nm of the other surface satisfy the following formula (3): $T ′ α > T ′ β$ (3) and
   a height H (µm) is 100 µm or more.
[5] The cured product according to [4], wherein a width L0 (µm) of the surface on the side where the transmittance per unit thickness at a wavelength of 405 nm of the cured product is T'α (%) and a width L100 (µm) of the surface on the side where the transmittance per unit thickness at a wavelength of 405 nm is T'β (%) satisfy the following formula (4): $L 0 / L 100 \leq 0.90$ (4)
[6] The cured product according to [4] or [5], wherein, when a width at a depth of n% relative to the height H (µm) of the cured product from the surface on the side where the transmittance per unit thickness at a wavelength of 405 nm of the cured product is T'α (%) is defined as Ln, the following formula (5) is satisfied in a range where n is 0 to 99%: $\left\{L\left(n+1\right)-Ln\right\} / \left(L100-L0\right) < 0.10$ (5)
[7] The cured product according to any of [4] to [6], wherein a width L0 (µm) of the surface on the side where the transmittance per unit thickness at a wavelength of 405 nm of the cured product is T'α (%), a width L100 (µm) on the side where the transmittance per unit thickness at a wavelength of 405 nm is T'β (%), and the height H (µm) satisfy the following formula (7): $H / \left\{\left(L0+L100\right)/2\right\} > 16.0$ (7)
[8] The cured product according to any of [4] to [7], wherein the resin (A) contains polyimide, polyamide, polyamideimide and/or polybenzoxazole.
[9] A method of producing a photosensitive resin composition film according to any of [1] to [3], comprising:
   a step of forming a first film using a first photosensitive resin composition containing (A) a resin, (B) an epoxy compound and/or an oxetane compound, and (C) a photocationic polymerization initiator; and
   a step of forming a second film on the first film using a second photosensitive resin composition containing (A) a resin, (B) an epoxy compound and/or an oxetane compound, and (C) a photocationic polymerization initiator,
   wherein content of the (C) photocationic polymerization initiator in the first photosensitive resin composition and content of the (C) photocationic polymerization initiator in the second photosensitive resin composition are different.
[10] A method of producing a cured product according to any of [4] to [8], comprising: an exposure step of imagewise exposing the photosensitive resin composition film according to any of [1] to [3]; and
   a development step of removing unexposed portions using a developer.
[11] A scintillator panel comprising a substrate, a partition wall formed on the substrate, and a phosphor layer filled in cells partitioned by the partition wall, wherein the partition wall consists of the cured product according to any of [4] to [8].
[12] A semiconductor device comprising a semiconductor element and an insulating film, wherein the insulating film consists of the cured product according to any of [4] to [8].

### EFFECTS OF THE INVENTION

According to the photosensitive resin composition film of the present invention, a high aspect ratio pattern can be easily formed.

### BRIEF DESCRIPTION OF THE DRAWINGS

FIG. 1 is a cross-sectional view schematically showing a radiation detector member including the scintillator panel of the present invention.
FIG. 2 is an enlarged cross-sectional view schematically showing the substrate and partition wall portions of the radiation detector member shown in FIG. 1.
FIG. 3 is a cross-sectional view schematically showing the configuration of an inductor, which is one embodiment of the semiconductor device of the present invention.

### MODE FOR CARRYING OUT THE INVENTION

The photosensitive resin composition film which is a first embodiment of the present invention contains (A) a resin, (B) an epoxy compound and/or an oxetane compound, and (C) a photocationic polymerization initiator. (A) The resin has the effect of maintaining the shape of the photosensitive resin composition film and improving processability. By containing (B) the epoxy compound and/or the oxetane compound and (C) the photocationic polymerization initiator, the (C) photocationic polymerization initiator generates an acid upon irradiation with light, whereby (B) the epoxy compound and/or the oxetane compound is cured by cationic polymerization and shows negative-type photosensitivity that becomes insoluble in a developer. Pattern formation by negative-type photosensitivity can form a pattern excellent in mechanical properties because the photo-crosslinked exposed area forms the pattern. On the other hand, in a negative-type photosensitive resin composition film, the exposure amount reaching the bottom part attenuates as the film thickness increases, so the formed pattern tends to have a reverse tapered shape. A reverse tapered shape pattern has a small contact area with the substrate and tends to have decreased adhesion to the substrate. Therefore, with conventional negative-type photosensitive resin composition films, it was difficult to obtain a high aspect ratio pattern. The photosensitive resin composition film of the present invention can suppress the attenuation of the exposure amount reaching the bottom part by exposing from the surface side with high transmittance, and can obtain a high aspect ratio pattern.

### <(A) Resin>

Examples of the resin include acrylic resins, styrene-based resins, phenol resins, epoxy resins, polyesters, polyvinyl alcohol, polyamides, polyimides, polyamideimides, polybenzoxazoles, and the like. Two or more of these resins may be contained. Among these, resins selected from polyamides, polyimides, polyamideimides, and polybenzoxazoles are preferred, as they improve mechanical properties of a cured product obtained by curing the photosensitive resin composition film, and can form a pattern with a higher aspect ratio and a more forward tapered shape. Resins selected from polyimides and polybenzoxazoles are more preferred.

The weight average molecular weight of (A) the resin is preferably 1,000 or more and 20,000 or less. By setting the weight average molecular weight of (A) the resin to 1,000 or more, the film-forming property of the photosensitive resin composition can be improved. The weight average molecular weight of (A) the resin is more preferably 2,000 or more. On the other hand, by setting the weight average molecular weight of (A) the resin to 20,000 or less, the solubility of the photosensitive resin composition film in a developer can be improved. The weight average molecular weight of (A) the resin is more preferably 10,000 or less. The weight average molecular weight of (A) the resin in the present invention is measured by a gel permeation chromatography method (GPC method) and calculated in terms of polystyrene.

From the viewpoint of cationic polymerization, (A) the resin preferably does not substantially have a basic functional group such as an amino group that can be an inhibiting group for cationic polymerization. By not substantially having a cationic polymerization inhibiting group, cationic polymerization property is enhanced, and a pattern with a higher aspect ratio can be formed. Here, "does not substantially have" specifically means that the equivalent of the basic functional group is 1,000 g/eq or more.
(A) The resin preferably has an alkali-soluble group, and since the photosensitive resin composition film comes to have appropriate solubility in an alkaline developer, the contrast between the exposed area and the unexposed area can be increased. Examples of the alkali-soluble group include a phenolic hydroxyl group, a carboxy group, a silanol group, a sulfo group, and the like. Two or more of these may be present. Among these, a phenolic hydroxyl group is preferred. Examples of the resin having a phenolic hydroxyl group include polyhydroxyphenyl acrylate, polyhydroxyphenyl methacrylate, poly-p-hydroxystyrene, and polyamides, polyimides, polyamideimides, and polybenzoxazoles having a phenolic hydroxyl group. Two or more of these may be contained.

Polyamides, polyimides, polyamideimides, and polybenzoxazoles having a phenolic hydroxyl group preferably have a diamine residue having a phenolic hydroxyl group. Examples of the diamine residue having a phenolic hydroxyl group include aromatic diamines such as bis(3-amino-4-hydroxyphenyl)hexafluoropropane, bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, 2,2'-ditrifluoromethyl-5,5'-dihydroxyl-4,4'-diaminobiphenyl, bis(3-amino-4-hydroxyphenyl)fluorene, and 2,2'-bis(trifluoromethyl)-5,5'-dihydroxybenzidine, or residues derived from compounds in which a part of the hydrogen atoms of these aromatic rings or hydrocarbons are substituted with an alkyl group having 1 to 10 carbon atoms, a fluoroalkyl group, a halogen atom, or the like. Two or more of these residues may be present, and a diamine residue not having a phenolic hydroxyl group may further be present.

The content of (A) the resin in the photosensitive resin composition film of the present invention is preferably 15 to 70 % by mass in the solid content. By containing 15 % by mass or more of (A) the resin, the mechanical properties and thermal properties of a cured product obtained by curing the photosensitive resin composition film can be improved. The content of (A) the resin is more preferably 25 % by mass or more. On the other hand, by containing 70 % by mass or less of (A) the resin, development residue of the photosensitive resin composition film can be suppressed. The content of (A) the resin is more preferably 60 % by mass or less. Here, the solid content refers to all components in the components contained in the composition, excluding the solvent.

### <(B) Epoxy compound and/or oxetane compound>

In the present invention, a compound having an epoxy group or an oxetanyl group shall be classified as (B) an epoxy compound and/or an oxetane compound regardless of the molecular weight.

Examples of the epoxy compound include aromatic epoxy compounds, alicyclic epoxy compounds, aliphatic epoxy compounds, and the like. Two or more of these may be contained.

Examples of the aromatic epoxy compound include glycidyl ethers of monovalent or polyvalent phenols having at least one aromatic ring (phenol, bisphenol A, phenol novolac, or compounds obtained by adding an alkylene oxide thereto), and the like.

Examples of the alicyclic epoxy compound include compounds obtained by epoxidizing a compound having at least one cyclohexene or cyclopentene ring with an oxidizing agent (such as 3,4-epoxycyclohexylmethyl-3,4-epoxycyclohexanecarboxylate).

Examples of the aliphatic epoxy compound include polyglycidyl ethers of aliphatic polyhydric alcohols or alkylene oxide adducts thereof (such as 1,4-butanediol diglycidyl ether and 1,6-hexanediol diglycidyl ether), polyglycidyl esters of aliphatic polybasic acids (such as diglycidyl tetrahydrophthalate), epoxidized products of long-chain unsaturated compounds (such as epoxidized soybean oil and epoxidized polybutadiene), and the like.

Examples of the oxetane compound include 3-methyl-3-hydroxymethyloxetane, 3-ethyl-3-hydroxymethyloxetane, 2-ethylhexyl (3-ethyl-3-oxetanylmethyl) ether, 2-hydroxyethyl (3-ethyl-3-oxetanylmethyl) ether, 2-hydroxypropyl (3-ethyl-3-oxetanylmethyl) ether, 1,4-bis[(3-ethyl-3-oxetanylmethoxy)methyl]benzene, oxetanyl silsesquioxane, phenol novolac oxetane, OXT-191 (trade name, manufactured by Toagosei Co., Ltd.), and the like. Two or more of these may be contained.

The oxetane compound preferably has two or more oxetanyl groups, and since it is excellent in curability, a pattern with a higher aspect ratio can be formed. The oxetane compound more preferably has 4 or more oxetanyl groups, and still more preferably 7 or more oxetanyl groups. Examples of the oxetane compound having 4 or more oxetanyl groups include oxetanyl silsesquioxane, phenol novolac oxetane, OXT-191 (trade name, manufactured by Toagosei Co., Ltd.), and the like. On the other hand, the oxetane compound preferably has 20 or less oxetanyl groups, which can suppress the occurrence of cracks during pattern processing. Examples of the oxetane compound having 7 or more and 20 or less oxetanyl groups include OXT-191 (trade name, manufactured by Toagosei Co., Ltd.) and the like.

The oxetanyl compound preferably has a structure represented by the following general formula (1).

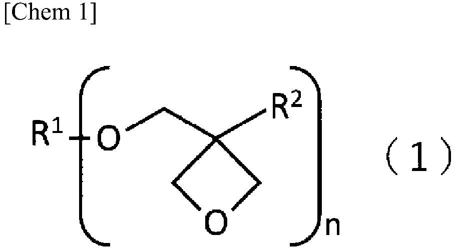

In the above general formula (1), R¹ represents an n-valent group having a siloxane bond. R² represents a hydrogen atom or a monovalent organic group having 1 to 6 carbon atoms. n represents a range of 4 to 30, and a range of 7 to 20 is preferred.

R¹ has a siloxane bond. Since the siloxane bond is hydrolyzed by an alkaline developer, the photosensitive resin composition film has appropriate solubility in an alkaline developer, and thus the contrast between the exposed area and the unexposed area can be increased. As R¹, a silicate or a polysilicate is preferred.

As the organic group constituting R², for example, alkyl groups such as a methyl group and an ethyl group are preferred. The alkyl group may be substituted with a halogen such as fluorine, and when it has a substituent, for example, a perfluoroalkyl group such as a trifluoromethyl group and a pentafluoroethyl group is preferred. When R² is a hydrogen atom or a monovalent organic group having 1 to 6 carbon atoms, the photosensitive resin composition film is excellent in solubility in an alkaline developer, and the development property can be improved.

Examples of the oxetane compound having a structure represented by the above general formula (1) include oxetanyl silsesquioxane, OXT-191 (trade name, manufactured by Toagosei Co., Ltd.), and the like.

The oxetane compound and the epoxy compound preferably have a polyalkylene glycol chain. By having a highly flexible polyalkylene glycol chain, the occurrence of cracks in the photosensitive resin composition film or the cured product after drying can be suppressed. When two or more types of the oxetane compound and the epoxy compound are contained, it is preferred that at least a part of them has a polyalkylene glycol chain.

The number average molecular weight of the oxetane compound and/or the epoxy compound having a polyalkylene glycol chain is preferably 300 to 4,000 from the viewpoint of compatibility with (A) the resin. By setting the number average molecular weight to 300 or more, the compatibility with (A) the resin and flexibility can be further improved, and the occurrence of cracks can be further suppressed. On the other hand, by setting the number average molecular weight to 4,000 or less, the epoxy/oxetane equivalent is appropriately suppressed, the curability is further improved, and a pattern with a higher aspect ratio can be formed. The chemical structure of the compound having a polyalkylene glycol chain can be analyzed by combining nuclear magnetic resonance (NMR), Fourier transform infrared spectroscopy (FT-IR), high performance liquid chromatography/mass spectrometry (HPLC/MS), and the like. The number average molecular weight of the compound having a polyalkylene glycol chain can be measured by a gel permeation chromatography method (GPC method).

The number of carbon atoms of the alkylene group in the repeating unit of the polyalkylene glycol chain is preferably 2 to 6, and more preferably 2, from the viewpoint of hydrophilicity. By setting the number of carbon atoms of the alkylene group within such a range, solubility in an alkaline developer is excellent, and the development property of the photosensitive resin composition film can be improved.

The number of epoxy groups and oxetanyl groups in the oxetane compound and/or the epoxy compound having a polyalkylene glycol chain is preferably 2 or more, which further improves the curability of the photosensitive resin composition film and can form a pattern with a higher aspect ratio. Examples of such an oxetane compound include bis-[(3-ethyloxetan-3-yl)methoxy]polyethylene glycol and the like. Examples of such an epoxy compound include polyethylene glycol diglycidyl ether, polypropylene glycol diglycidyl ether, and the like.

The oxetane compound and the epoxy compound are preferably water-soluble compounds from the viewpoint of solubility in an aqueous developer during development. Specifically, at least one of the oxetane compound and/or the epoxy compound is preferably a water-soluble compound that dissolves in 900 parts by mass of water with respect to 100 parts by mass of the compound at 20°C within 1 minute. Examples of the water-soluble oxetane compound and/or epoxy compound include 3-methyl-3-hydroxymethyloxetane, 3-ethyl-3-hydroxymethyloxetane, glycerol polyglycidyl ether, polyglycerol polyglycidyl ether, ethylene glycol diglycidyl ether, polyethylene glycol diglycidyl ether, polypropylene glycol diglycidyl ether, phenol (EO)₅ glycidyl ether, lauryl alcohol (EO)₁₅ glycidyl ether, and the like.

The total content of (B) the oxetane compound and the epoxy compound in the photosensitive resin composition film of the present invention is preferably 50 to 170 parts by mass relative to 100 parts by mass of the content of (A) the resin. By setting the total content of these to 50 parts by mass or more, cracks in the photosensitive resin composition film can be suppressed. The total content of these is more preferably 70 parts by mass or more. On the other hand, by setting the total content of these to 170 parts by mass or less, tack of the photosensitive resin composition film can be suppressed. The total content of these is more preferably 140 parts by mass or less.

### <(C) Photocationic polymerization initiator>

(C) The photocationic polymerization initiator generates an acid by light and causes cationic polymerization. Examples of (C) the photocationic polymerization initiator include aromatic iodonium salts, aromatic sulfonium salts, aromatic borate salts, and the like. Two or more of these may be contained. Among these, aromatic sulfonium salts are preferred. Specifically, for example, diphenyl[(phenylsulfanyl)phenyl]sulfonium hexafluorophosphate, diphenyl[4-(phenylthio)phenyl]sulfonium hexafluoroantimonate (V), diphenyl[4-(phenylsulfanyl)phenyl]sulfonium trifluorotris(pentafluoroethane-1-ide)phosphate, diphenyl[(phenylsulfanyl)phenyl]sulfonium tetrakis(pentafluorophenyl)borate, CPI-310B, CPI-310FG, CPI-410S, CPI-410B (trade names, all manufactured by San-Apro Ltd.), and the like can be mentioned. Among these, aromatic sulfonium phosphate salts such as CPI-410S, diphenyl[(phenylsulfanyl)phenyl]sulfonium hexafluorophosphate, and diphenyl[4-(phenylsulfanyl)phenyl]sulfonium trifluorotris(pentafluoroethane-1-ide)phosphate are more preferred because they are difficult to color, easy to maintain high transmittance, have high cationic polymerization reactivity, and can form a pattern with a higher aspect ratio.

The content of (C) the photocationic polymerization initiator in the photosensitive resin composition film of the present invention is preferably 0.1 parts by mass or more relative to 100 parts by mass of the content of (A) the resin, which further improves the curability of the photosensitive resin composition film and can form a pattern with a higher aspect ratio. On the other hand, the content of (C) the photocationic polymerization initiator is preferably 10 parts by mass or less relative to 100 parts by mass of the content of (A) the resin, which can improve the stability of the photosensitive resin composition film.

### <Other components>

The photosensitive resin composition film of the present invention may contain, together with (B) the epoxy compound and/or the oxetane compound, cationic polymerizable compounds other than these. Examples of the cationic polymerizable compounds other than (B) the epoxy compound and/or the oxetane compound include ethylenically unsaturated compounds, bicyclo orthoesters, spiro orthocarbonates, spiro orthoesters, and the like. Two or more of these may be contained.

Examples of the ethylenically unsaturated compounds include aliphatic monovinyl ethers, aromatic monovinyl ethers, polyfunctional vinyl ethers, styrenes, cationic polymerizable nitrogen-containing monomers, and the like. Examples of the aliphatic monovinyl ethers include methyl vinyl ether, ethyl vinyl ether, butyl vinyl ether, cyclohexyl vinyl ether, and the like. Examples of the aromatic monovinyl ethers include 2-phenoxyethyl vinyl ether, phenyl vinyl ether, p-methoxyphenyl vinyl ether, and the like. Examples of the polyfunctional vinyl ethers include butanediol-1,4-divinyl ether, triethylene glycol divinyl ether, and the like. Examples of the styrenes include styrene, α-methylstyrene, p-methoxystyrene tert-butoxystyrene, and the like. Examples of the cationic polymerizable nitrogen-containing monomers include N-vinylcarbazole, N-vinylpyrrolidone, and the like.

Examples of the bicyclo orthoesters include 1-phenyl-4-ethyl-2,6,7-trioxabicyclo[2.2.2]octane, 1-ethyl-4-hydroxymethyl-2,6,7-trioxabicyclo-[2.2.2]octane, and the like.

Examples of the spiro orthocarbonates include 1,5,7,11-tetraoxaspiro[5.5]undecane, 3,9-dibenzyl-1,5,7,11-tetraoxaspiro[5.5]undecane, and the like.

Examples of the spiro orthoesters include 1,4,6-trioxaspiro[4.4]nonane, 2-methyl-1,4,6-trioxaspiro[4.4]nonane 1,4,6-trioxaspiro[4.5]decane, and the like.

The photosensitive resin composition film of the present invention may further contain, as necessary, additives such as a sensitizer and a surfactant, inorganic particles, and the like.

### <Photosensitive resin composition film>

The photosensitive resin composition film of the present invention is such that the transmittance Tα (%) per unit film thickness at a wavelength of 405 nm on one surface and the transmittance Tβ (%) per unit film thickness at a wavelength of 405 nm on the other surface satisfy the following formula (1); that is, the transmittances of one surface and the other surface are different. However, the transmittance of the surface having a higher transmittance per unit film thickness at a wavelength of 405 nm is Tα, and the transmittance of the surface having a lower transmittance is Tβ. Here, in the present invention, "transmittance per unit film thickness" is the transmittance per 20 µm. That is, the transmittance per unit film thickness of the surface is the transmittance measured in the width direction for the vicinity of one surface and the vicinity of the other surface of a sample with a width of 20 µm cut out from the photosensitive resin composition film. $Tα > Tβ$ (1).

As described above, in the photosensitive resin composition film having negative-type photosensitivity, the exposure amount of light reaching the bottom part tends to attenuate as the film thickness increases. In the present invention, by exposing from the surface side where the transmittance per unit film thickness at a wavelength of 405 nm is Tα (%) (hereinafter sometimes referred to as the "high transmittance side surface"), that is, by exposing from the high transmittance surface, a high exposure amount can be maintained down to the other surface (bottom part) (hereinafter sometimes referred to as the "low transmittance side surface"), and a high aspect ratio pattern can be formed. Here, in the present invention, the transmittance at a wavelength of 405 nm was focused on as a representative wavelength among ultraviolet lights generally used for exposure, and was used as an index of ultraviolet light transparency. The difference between Tα (%) and Tβ (%) is preferably 0.5% or more, and more preferably 2% or more.

Examples of the embodiment of the photosensitive resin composition film satisfying the above formula (1) include an embodiment in which the transmittance continuously changes from one surface toward the other surface, and an embodiment in which the transmittance changes stepwise. Among these, from the viewpoint of smoothing the shape of the cured product, an embodiment in which the transmittance continuously changes is more preferred.

Here, the transmittance Tα (%) and the transmittance Tβ (%) are measured by cutting three randomly selected locations from the photosensitive resin composition film in a direction perpendicular to the surface with a width of 20 µm to cut out samples with a thickness of 20 µm. For these samples, the transmittance in the thickness direction is measured in the vicinity of one surface and the vicinity of the other surface of the varnish coating film using a microspectrophotometer, and by calculating the average value, the transmittance Tα (%) and the transmittance Tβ (%) can be obtained.

As a method of making the transmittance Tα (%) and the transmittance Tβ (%) satisfy formula (1), for example, a method of changing the concentration of a compound that absorbs light with a wavelength of 405 nm in the film thickness direction can be mentioned. More specifically, a preferred embodiment described later, for example, a photosensitive resin composition film satisfying formula (2) described later, can be mentioned.

The photosensitive resin composition film of the present invention is such that the content C10 (% by mass) of (C) the photocationic polymerization initiator at a depth of 10% from the high transmittance side surface relative to its thickness, and the content C90 (% by mass) of (C) the photocationic polymerization initiator at a depth of 90% from the high transmittance side surface relative to its thickness preferably satisfy the following formula (2). $0.050 \leq C 10 / C 90 \leq 0.85$ (2).

Here, C10 is an index of the content of (C) the photocationic polymerization initiator on the high transmittance side surface, and C90 is an index of the content of (C) the photocationic polymerization initiator on the low transmittance side surface. Since (C) the photocationic polymerization initiator easily absorbs light with a wavelength of 405 nm, as C10 is made smaller than C90, Tα is made larger than Tβ, and a pattern with a higher aspect ratio can be formed. In addition, as the content of (C) the photocationic polymerization initiator is larger, the sensitivity improves and the pattern becomes thicker; thus, by making C90 larger than C10, a forward tapered shape pattern can be more easily formed. For this reason, C10/C90 is preferably 0.85 or less. On the other hand, by making C10 appropriately large, the curability of the photosensitive resin composition film is further improved, and a pattern with a higher aspect ratio can be formed. C10/C90 is preferably 0.050 or more, more preferably 0.20 or more, more preferably 0.30 or more, and still more preferably 0.45 or more.

Examples of the embodiment satisfying the above formula (2) include an embodiment in which the content of (C) the photocationic polymerization initiator changes continuously from one surface toward the other surface, and an embodiment in which the content of (C) the photocationic polymerization initiator changes stepwise. From the viewpoint of smoothing the shape of the cured product, an embodiment in which the content changes continuously is more preferred.

Here, C10 and C90 can be measured by the following method. First, for a photosensitive resin composition film of 10 cm × 10 cm, the high transmittance side surface and the low transmittance side surface are each shaved with a file to a depth of 10%, and 100 mg of each part near the depth of 10% from the high transmittance side surface and near the depth of 90% is collected and used as a measurement sample. The chemical structure of (C) the photocationic polymerization initiator contained in the measurement sample is identified by combining NMR, FT-IR, HPLC/MS, and the like. After adding 0.5 mL of acetonitrile to 10 mg of each measurement sample, ultrasonic treatment is performed for 60 minutes, followed by centrifugation at 20,000 g for 15 minutes. A part of the supernatant after centrifugation is transferred to a brown measurement vial, and the peak of the anionic component derived from (C) the photocationic polymerization initiator is quantitatively analyzed by HPLC. From the content of the anionic component, the total content of the anion and cation derived from (C) the photocationic polymerization initiator is calculated, whereby C10 and C90 can be determined. Note that if the structure of (C) the photocationic polymerization initiator is known, the content of (C) the photocationic polymerization initiator can be calculated from the known structure and the quantitative analysis result by HPLC.

As a method of making C10 and C90 satisfy formula (2), for example, it is preferred that the photosensitive resin composition film is a laminate of a plurality of photosensitive resin composition films having different contents of (C) the photocationic polymerization initiator, and more specifically, a method of manufacturing a photosensitive resin composition film by a preferred manufacturing method described later can be mentioned.

The photosensitive resin composition film of the present invention has a first film made of a first photosensitive resin composition containing (A) a resin, (B) an epoxy compound and/or an oxetane compound, and (C) a photocationic polymerization initiator, and a second film made of a second photosensitive resin composition containing (A) a resin, (B) an epoxy compound and/or an oxetane compound, and (C) a photocationic polymerization initiator, and it is preferred that the content of (C) the photocationic polymerization initiator in the first photosensitive resin composition and the content of (C) the photocationic polymerization initiator in the second photosensitive resin composition are different. With the configuration having the first film and the second film with different contents of (C) the photocationic polymerization initiator, the content of (C) the photocationic polymerization initiator can be easily adjusted to a desired range. Among the first film and the second film, the ratio of the content of (C) the photocationic polymerization initiator in the film with a smaller content of (C) the photocationic polymerization initiator to the content of (C) the photocationic polymerization initiator in the film with a larger content of (C) the photocationic polymerization initiator is preferably 0.050 or more, more preferably 0.20 or more, still more preferably 0.30 or more, and still more preferably 0.45 or more. On the other hand, such a content ratio is preferably 0.85 or less, and more preferably 0.75 or less.

The photosensitive resin composition film of the present invention may further have a protective film on its surface, which can protect the surface from pollutants such as dust and dirt in the atmosphere. Examples of the protective film include polyolefin films, polyester films, and the like. It is preferred that the protective film has low adhesion to the photosensitive resin composition film.

The thickness of the photosensitive resin composition film of the present invention is preferably 100 µm or more from the viewpoint of forming a pattern with a higher aspect ratio. On the other hand, the thickness of the photosensitive resin composition film of the present invention is preferably 1,000 µm or less from the viewpoint of suppressing variation in film thickness.

Next, a method of manufacturing the photosensitive resin composition film of the present invention will be described. The photosensitive resin composition film of the present invention can be obtained, for example, by mixing (A) a resin, (B) an epoxy compound and/or an oxetane compound, (C) a photocationic polymerization initiator, and if necessary, a solvent and other components to prepare a photosensitive resin composition liquid (varnish), applying this onto a support, and then drying it if necessary.

As the solvent, one that dissolves the components constituting the photosensitive resin composition is preferred, and examples thereof include propylene glycol monomethyl ether, propylene glycol monomethyl ether acetate, 3-methyl-3-methoxybutyl acetate acetone 3-methyl-3-methoxybutanol N-methyl-2-pyrrolidone, N,N-dimethylacetamide, gamma-butyrolactone, and the like. Two or more of these may be used.

Before applying the varnish, it may be filtered using filter paper or a filter. As the filtration method, pressure filtration is preferred, and as the filter, one having a retained particle size of 0.4 to 50 µm is preferred.

Examples of the support include polyethylene terephthalate (PET) films, polyphenylene sulfide films, polyimide films, and the like. The thickness of the support is preferably 10 to 100 µm. The support may be surface-treated, and the adhesion and peelability with the photosensitive resin composition film can be adjusted. Examples of the surface treatment agent include silicone, silane coupling agents, aluminum chelate agents, polyurea, and the like.

Examples of the method of applying the varnish onto the support include application methods using a coater such as screen printing, rotational coating using a spinner, spray coating, a bar coater, a roll coater, a die coater, a blade coater, a calendar coater, a meniscus coater, a gravure coater, and a slit die coater.

Examples of the drying apparatus include hot air ovens, hot plates, infrared ovens, and the like. The drying temperature and drying time are preferably set appropriately within ranges such that the solvent is volatilized and the photosensitive resin composition film is in an uncured or semi-cured state. Specifically, the drying temperature is preferably 50 to 150°C, and the drying time is preferably 1 minute to several hours. The drying temperature may be raised stepwise; for example, drying may be performed at 70°C, 80°C, and 90°C for 1 minute to several tens of minutes each.

In the present invention, it is preferred to laminate a plurality of photosensitive resin composition films having different contents of (C) the photocationic polymerization initiator, so that C10 and C90 can easily satisfy the above formula (2). More specifically, it is preferred to have a step of forming a first film using a first photosensitive resin composition containing (A) a resin, (B) an epoxy compound and/or an oxetane compound, and (C) a photocationic polymerization initiator, and a step of forming a second film on the first film using a second photosensitive resin composition containing (A) a resin, (B) an epoxy compound and/or an oxetane compound, and (C) a photocationic polymerization initiator, wherein the content of (C) the photocationic polymerization initiator in the first photosensitive resin composition and the content of (C) the photocationic polymerization initiator in the second photosensitive resin composition are different. The ratio of the content of (C) the photocationic polymerization initiator in the first photosensitive resin composition to the content of (C) the photocationic polymerization initiator in the second photosensitive resin composition is preferably 0.050 or more, more preferably 0.20 or more, more preferably 0.30 or more, and still more preferably 0.45 or more. On the other hand, such a content ratio is preferably 0.85 or less, and more preferably 0.75 or less.

Examples of the method of forming the second film on the first film include a method in which, after forming the first film, a second photosensitive resin composition liquid (varnish) is applied on the first film and dried, and a method in which, after forming the first film and the second film respectively, they are subjected to thermocompression bonding. When the photosensitive resin composition film is prepared by the former method, components diffuse at the interface between the first film and the second film, whereby the concentration of (C) the photocationic polymerization initiator changes continuously in the vicinity of the interface. This can suppress the occurrence of steps at the interface when the photosensitive resin composition film is exposed and developed to form a pattern. Since steps at the interface are suppressed in the pattern formed from such a photosensitive resin composition film, for example, when used as a partition wall of a scintillator panel described later, the reflectance is improved, and the luminance of the scintillator panel can be further improved. In addition, when used as an insulating layer of a semiconductor device or an electronic component described later, adhesion to coil wiring is improved, and the temperature cycle durability of the semiconductor device or the electronic component can be improved.

In the former method, the drying time of the first film is preferably about 30 minutes to 1.5 hours. A longer drying time for the second film is preferred. By increasing the drying time of the second film, (C) the photocationic polymerization initiator is further diffused at the interface between the first film and the second film, so that steps at the interface can be further suppressed. The drying time of the second film is preferably 1 hour or more, more preferably 2 hours or more, and still more preferably 3 hours or more. On the other hand, the drying time of the second film is preferably 6 hours or less, and more preferably 5 hours or less, from the viewpoint of improving the development speed.

### <Cured product>

A cured product which is a second embodiment of the present invention is formed by curing a photosensitive resin composition containing the aforementioned (A) resin, (B) epoxy compound and/or oxetane compound, and (C) photocationic polymerization initiator. As such a photosensitive resin composition, the composition constituting the aforementioned photosensitive resin composition film of the present invention is preferred.

The cross-sectional shape of the cured product of the present invention is preferably a trapezoid.

In the cured product of the present invention, the transmittance T'α (%) per unit thickness at a wavelength of 405 nm on one surface and the transmittance T'β (%) per unit thickness at a wavelength of 405 nm on the other surface satisfy the following formula (3). However, the transmittance of the surface having a higher transmittance per unit film thickness at a wavelength of 405 nm is T'α, and the transmittance of the surface having a lower transmittance is T'β. Note that the surface having a transmittance per unit film thickness at a wavelength of 405 nm of T'α (%) may be referred to as the "high transmittance side surface," and the surface having T'β (%) as the "low transmittance side surface." Here, in the present invention, "transmittance per unit film thickness" is the transmittance per 20 µm. That is, the transmittance per unit film thickness of the surface is the transmittance measured in the width direction for the vicinity of one surface and the vicinity of the other surface of a sample with a width of 20 µm cut out from the cured product. $T ′ α > T ′ β$ (3).

Under general curing conditions, the magnitude relationship of the transmittance of both surfaces before curing matches the magnitude relationship of the transmittance of both surfaces after curing; therefore, when the cured product satisfies the above formula (3), the aforementioned formula (1) is satisfied in the state before curing. For this reason, when the photosensitive resin composition film is exposed and developed to form a pattern, by exposing from the high transmittance side surface, a high exposure amount can be maintained down to the bottom part, and a high aspect ratio pattern can be formed. Here, in the present invention, the transmittance at a wavelength of 405 nm was focused on as a representative wavelength among ultraviolet lights generally used for exposure, and was used as an index of ultraviolet light transparency. The difference between Tα' (%) and T'β (%) is preferably 0.5% or more, and more preferably 2.0% or more.

Examples of the embodiment satisfying the above formula (3) include an embodiment in which the transmittance continuously changes from one surface toward the other surface, and an embodiment in which the transmittance changes stepwise. Among these, from the viewpoint of smoothing the shape of the cured product, an embodiment in which the transmittance continuously changes is more preferred.

Here, the transmittance T'α (%) and the transmittance T'β (%) can be measured in the same manner as the transmittances Tα (%) and Tβ (%) of the photosensitive resin composition film.

As a method of making T'α (%) and T'β (%) satisfy the above formula (3), for example, a method of forming a cured product from the photosensitive resin composition film of the aforementioned preferred embodiment of the present invention is preferred.

The height H (µm) of the cured product of the present invention is preferably 100 µm or more from the viewpoint of obtaining a cured product with a higher aspect ratio.

In the cured product of the present invention, it is preferred that the top width L0 (µm) of the high transmittance side surface and the bottom width L100 (µm) of the low transmittance side surface satisfy the following formula (4). L0/L100 being less than 1 means that the cross-sectional shape of the cured product is a forward tapered shape. $L 0 / L 100 \leq 0.90$ (4) L0/L100 is preferably 0.70 or more, and more preferably 0.75 or more. On the other hand, L0/L100 is more preferably 0.85 or less.

In the cured product of the present invention, when Ln is the width of the cured product at a depth of n% with respect to the height H (µm) of the cured product from the surface having a transmittance per unit thickness at a wavelength of 405 nm of T'α (%), it is preferred that the following formula (5) is satisfied in the entire range of n from 0 to 99%. A smaller maximum value of the absolute value of {L(n+1) - Ln} / (L100 - L0) in the range of n from 0 to 99% (hereinafter sometimes referred to as the "maximum rate of change in width") indicates smaller variation in width in the depth direction of the cured product, meaning a shape in which steps at the interface of the cured product are further suppressed. $\left\{L\left(n+1\right)-Ln\right\} / \left(L100-L0\right) < 0.10$ (5) In addition, for the same reason, the cured product of the present invention preferably satisfies the following formula (6). $\left\{L\left(n+1\right)-Ln\right\} / \left(L100-L0\right) > - 0.10$ (6) The maximum rate of change in width is more preferably less than 0.060, and still more preferably less than 0.040.

In the cured product of the present invention, the top width L0 (µm) of the high transmittance side surface, the bottom width L100 (µm) of the low transmittance side surface, and the height H (µm) preferably satisfy the following formula (7).
H / {(L0 + L100) / 2} represents the aspect ratio of the cured product of the present invention, and a larger value means a larger aspect ratio. $H / \left\{\left(L0+L100\right)/2\right\} > 16.0$ (7).

The aspect ratio is more preferably 18.0 or more, more preferably larger than 18.0, more preferably 19.5 or more, and still more preferably larger than 19.5.

Here, the top width L0 (µm) of the high transmittance side surface, the bottom width L100 (µm) of the low transmittance side surface, and the height H (µm) are determined by cutting a cross-section in a direction perpendicular to the surface and perpendicular to the long side at three randomly selected locations from the cured product, or by enlarging and observing a cross-section exposed by polishing with a polishing device such as a cross section polisher using a scanning electron microscope, measuring L0, L100, and H respectively, and calculating the average values.

As a method of making the top width L0 of the high transmittance side surface and the bottom width L100 of the low transmittance side surface satisfy the above formula (4), for example, a method of forming a cured product from the photosensitive resin composition film of the aforementioned preferred embodiment of the present invention is preferred.

As a method of making the widths Ln and L(n+1) at a depth of n% with respect to the height H (µm) of the cured product from the surface of T'α (%) satisfy the above formulas (5) and (6), for example, a method of forming a cured product from the photosensitive resin composition film of the preferred embodiment of the present invention obtained by the aforementioned preferred manufacturing method is preferred.

As a method of making the top width L0 of the high transmittance side surface, the bottom width L100 of the low transmittance side surface, and the height H satisfy the above formula (7), for example, a method of forming a cured product from the photosensitive resin composition film of the aforementioned preferred embodiment of the present invention is preferred.

The cured product of the present invention can be suitably used, for example, for insulating films of semiconductor devices, partition walls of scintillator panels, electronic components, and the like described later.

### <Method of manufacturing cured product>

Next, a method of manufacturing the cured product of the present invention will be described. The cured product of the present invention is obtained, for example, by patterning a photosensitive resin composition containing (A) a resin, (B) an epoxy compound and/or an oxetane compound, (C) a photocationic polymerization initiator, and if necessary, a solvent and other components, followed by curing.

As the curing method, a method of irradiation with actinic radiation (exposure) is preferred. If necessary, heating may be further performed after exposure. By heating, curing can be performed through a thermal crosslinking reaction and a cationic polymerization reaction by (C) the photocationic polymerization initiator.

The patterning method preferably has an exposure step of imagewise exposing the aforementioned photosensitive resin composition film of the present invention, and a development step of removing unexposed areas using a developer.

First, the photosensitive resin composition film is imagewise exposed. Specifically, in the exposure step, the photosensitive resin composition film is exposed by irradiating actinic radiation through a mask having a desired pattern onto the photosensitive resin composition film. Examples of actinic radiation used for exposure include ultraviolet rays, visible light, electron beams, X-rays, and the like. In the present invention, it is preferred to use the i-line (365 nm), h-line (405 nm), or g-line (436 nm) of a mercury lamp.

Next, in the development step, unexposed areas are removed with a developer.

Development can be performed by methods such as spraying a developer onto the photosensitive resin composition film surface, puddling a developer on the photosensitive resin composition film surface, or immersing the photosensitive resin composition film in a developer or immersing it and applying ultrasonic waves. Development conditions such as development time, development steps, and temperature of the developer may be any conditions as long as the exposed areas are removed and pattern formation is possible. Examples of the developer include those exemplified as developers in WO 2021/200327.

After development, it is preferred to perform rinsing treatment with water. Alcohols such as ethanol and isopropyl alcohol, esters such as ethyl lactate and propylene glycol monomethyl ether acetate, etc., may be added to water for rinsing treatment.

In addition, baking treatment may be performed before development as necessary. This may improve the resolution of the pattern after development and increase the tolerance of the development conditions. The temperature of this baking treatment is preferably in the range of 50 to 180°C, and particularly more preferably in the range of 60 to 120°C. The time is preferably 5 seconds to several hours.

After pattern formation, unreacted (B) epoxy compound and/or oxetane compound and (C) photocationic polymerization initiator remain in the photosensitive resin composition film. For this reason, these may thermally decompose and generate gas during a subsequent thermal crosslinking reaction. To avoid this, it is preferred to irradiate the entire surface of the photosensitive resin composition film after pattern formation with the aforementioned exposure light to generate acid from (C) the photocationic polymerization initiator. By doing so, the reaction of the unreacted (B) epoxy compound and/or oxetane compound proceeds during the subsequent thermal crosslinking reaction, and the generation of gas derived from thermal decomposition can be suppressed.

After development, it is preferred to cure the photosensitive resin composition into a cured product by applying a temperature of 120°C to 300°C to allow a thermal crosslinking reaction to proceed. Crosslinking can improve the heat resistance and chemical resistance of the resulting cured product. As for this heat treatment method, a method of selecting temperatures and raising the temperature stepwise, or a method of selecting a certain temperature range and carrying out for 5 minutes to 5 hours while continuously raising the temperature, can be selected.

### <Scintillator panel>

The scintillator panel of the present invention has a substrate, partition walls formed on the substrate, and a phosphor layer filled in cells partitioned by the partition walls, wherein the partition walls are made of the cured product of the present invention. It is preferred that the partition walls are provided in a direction substantially perpendicular to the substrate to form cells. The phosphor layer present in each cell is partitioned by the partition walls. According to the cured product of the present invention, high aspect ratio partition walls can be formed. By having high aspect ratio partition walls, the amount of phosphor filled in the cells can be increased, and the luminance of the scintillator panel can be improved.

Embodiments of the scintillator panel of the present invention will be described below with reference to the drawings. Note that the drawings are schematic. In addition, the present invention is not limited by the embodiments described below.

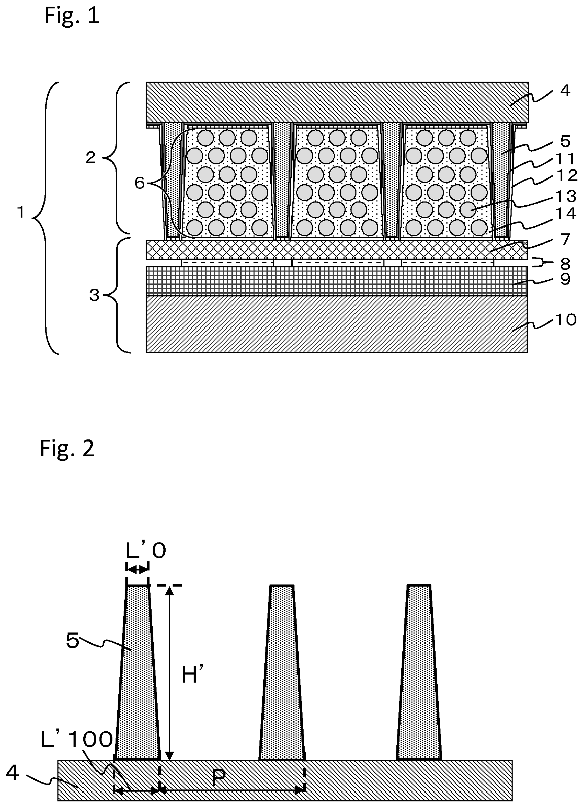

FIG. 1 shows a cross-sectional view schematically showing a radiation detector member including the scintillator panel of the present invention. The radiation detector member 1 has a scintillator panel 2 and an output substrate 3. The scintillator panel 2 has a substrate 4, partition walls 5, and a phosphor layer 6 in cells partitioned by the partition walls 5. A metal reflective layer 11 is formed on the surface of the partition walls 5, and an organic protective layer 12 is provided on its surface. The phosphor layer 6 includes a phosphor 13 and a binder resin 14. The output substrate 3 has an output layer 9 and a photoelectric conversion layer 8 having photodiodes in this order on a substrate 10. A diaphragm layer 7 may be provided on the photoelectric conversion layer 8. It is preferred that the light exit surface of the scintillator panel 2 and the photoelectric conversion layer 8 of the output substrate 3 are adhered or in close contact via the diaphragm layer 7. Light emitted in the phosphor layer 6 reaches the photoelectric conversion layer 8, where it is photoelectrically converted and output. Each of these will be described below.

### <Substrate>

The material constituting the substrate preferably has radiation transmittance. Examples of the material constituting the substrate include those exemplified as materials constituting substrates in WO 2021/200327. Among these, polymer materials having high radiation transmittance and high surface smoothness are preferred. As the polymer material, for example, polyesters such as polyethylene terephthalate and polyethylene naphthalate, polyamides, polyimides, etc., are preferred.

The thickness of the substrate is preferably 3.0 mm or less in the case of a substrate made of a polymer material.

### <Partition wall>

The partition walls are provided at least to form partitioned spaces (cells). Therefore, in a scintillator panel, each pixel of a photoelectric conversion element can be made to correspond to each cell of the scintillator panel by matching the size and pitch of pixels of photoelectric conversion elements arranged in a lattice with the size and pitch of cells of the scintillator panel. Thereby, a high-sharpness image can be obtained.

The partition walls are preferably made of the cured product of the present invention. By providing high aspect ratio partition walls made of the cured product of the present invention, the filling amount of the phosphor in the cells can be increased, and the luminance can be improved.

FIG. 2 is an enlarged cross-sectional view schematically showing the substrate and partition wall portions of the radiation detector member shown in FIG. 1. However, the vertical direction is opposite to that in FIG. 1. Partition walls 5 on the substrate 4 have a trapezoidal cross-sectional shape with a height H', a top width L'0, and a bottom width L'100, and are arranged at an interval P. Here, the height H', top width L'0, and bottom width L'100 of the partition wall correspond respectively to the height H, top width L0 of the high transmittance side surface, and bottom width L100 of the low transmittance side surface of the cured product of the present invention.

The height H' of the partition wall is preferably 100 µm or more. By setting H' to 100 µm or more, the phosphor filling amount can be increased, and the luminance can be further improved. H' is more preferably 200 µm or more. On the other hand, the height H' of the partition wall is preferably 3,000 µm or less. By setting H' to 3,000 µm or less, absorption of emitted light by the phosphor itself can be suppressed, and the luminance can be further improved. H' is more preferably 1,000 µm or less.

The interval P between adjacent partition walls is preferably 40 µm or more, and more preferably 1,000 µm or less. The bottom width L'100 of the partition wall is preferably 3 µm or more, and preferably 150 µm or less. The top width L'0 of the partition wall 5 is preferably 3 µm or more, and preferably 30 µm or less.

The aspect ratio (H' / ((L'0 + L'100) / 2)) represented by the ratio of the height H' of the partition wall to the average value of the top width L'0 and the bottom width L'100 of the partition wall is preferably 16 or more, more preferably larger than 16.0, whereby the phosphor filling amount can be increased and the luminance can be further improved. The aspect ratio is more preferably 18 or more, more preferably larger than 18.0, still more preferably 19.5 or more, and still more preferably larger than 19.5. On the other hand, the aspect ratio is preferably 100 or less, which can improve the strength of the partition wall. The aspect ratio is more preferably 50 or less.

The height H' of the partition wall, the interval P between adjacent partition walls, the bottom width L'100, and the top width L'0 can be measured by observing a cross-section perpendicular to the substrate and perpendicular to the long side direction, which has been cut or exposed by a polishing device such as a cross section polisher, using a scanning electron microscope. Here, the width of the partition wall at the contact portion between the partition wall and the substrate is L'100. In addition, the width of the topmost part of the partition wall is L'0. Each of the lengths H', L'0, L'100, and P is calculated by averaging measurement values for three randomly selected partition walls.

As a method of bringing the aspect ratio of the partition wall into the aforementioned range, a method of forming partition walls from the photosensitive resin composition film of the present invention is preferred, and it is more preferred to use the photosensitive resin composition film of the aforementioned preferred embodiment.

### <Metal reflective layer>

In the scintillator panel of the present invention, the partition walls preferably have a reflective layer containing metal (hereinafter referred to as a "metal reflective layer") on their surfaces. The metal reflective layer may be provided on at least a part of the partition walls. The metal reflective layer has high reflectance even as a thin film. Therefore, by providing the metal reflective layer which is a thin film, the reflectance of the partition walls can be improved without reducing the phosphor filling amount, so the luminance of the scintillator panel is further improved. Examples of the metal reflective layer include those exemplified as metal reflective layers in WO 2019/181444.

### <Protective layer>

The scintillator panel of the present invention preferably has a protective layer on the surface of the metal reflective layer. As the metal reflective layer, an alloy or the like having poor resistance to discoloration in the atmosphere is preferably used. However, even in such a case, by providing the protective layer, discoloration of the metal reflective layer can be reduced. It is considered that a decrease in the reflectance of the metal reflective layer due to reaction between the metal reflective layer and the phosphor layer is suppressed. Thereby, the luminance of the scintillator panel is further improved.

As the protective layer, both an inorganic protective layer and an organic protective layer can be suitably used. As the protective layer, an inorganic protective layer and an organic protective layer can also be laminated and used in combination.

### <Inorganic protective layer>

The inorganic protective layer is suitable as a protective layer because it has low water vapor permeability. Examples of the inorganic protective layer include those exemplified as inorganic protective layers in WO 2019/181444.

### <Organic protective layer>

The organic protective layer is preferably formed from a polymer compound having excellent chemical durability, and for example, preferably contains polysiloxane or an amorphous fluorine resin as a main component. Examples of the organic protective layer include those exemplified as organic protective layers in WO 2019/181444. Examples of polysiloxanes and amorphous fluorine resins include those exemplified as materials constituting organic protective layers in WO 2021/200327.

### <Phosphor layer>

The scintillator panel of the present invention has a phosphor layer in cells partitioned by partition walls.

The phosphor layer absorbs energy of incident radiation such as X-rays and emits electromagnetic waves in the wavelength range of 300 nm to 800 nm, that is, light in the range covering from ultraviolet light to infrared light centered on visible light. Light emitted in the phosphor layer is photoelectrically converted in the photoelectric conversion layer and output as an electrical signal through the output layer. The phosphor layer preferably has a phosphor and a binder resin.

### <Phosphor>

Examples of the phosphor include those exemplified as phosphors in WO 2021/200327. From the viewpoint of high luminous efficiency, terbium-activated rare earth oxysulfide phosphors are preferred as the phosphor.

### <Binder resin>

Examples of the binder resin include those exemplified as binder resins in WO 2021/200327.

The binder resin is preferably in contact with the protective layer. In this case, the binder resin only needs to be in contact with at least a part of the protective layer. Thereby, in the scintillator panel, the phosphor is unlikely to drop out from the cells. As shown in FIG. 1, the binder resin may be filled in the cells with almost no gaps, or may be filled so as to have gaps.

As described above, according to the scintillator panel of the present invention, high-luminance images can be obtained.

### <Method of manufacturing scintillator panel>

A method of manufacturing the scintillator panel of the present invention preferably includes, for example, a partition wall formation step of forming partition walls made of the cured product of the present invention on a substrate to partition cells, a reflective layer formation step of forming a metal reflective layer and a protective layer on the surfaces of the partition walls as necessary, and a filling step of filling cells partitioned by the partition walls with a phosphor. In the following description, descriptions of matters common to the matters described in the embodiments of the scintillator panel mentioned above will be omitted as appropriate.

### <Partition wall formation step>

On a substrate, partition walls of a desired shape are formed in the same manner as in the aforementioned <Method of manufacturing cured product>. In the method of manufacturing the scintillator panel of the present invention, a base material used during the formation of partition walls may be used as a substrate of the scintillator panel, or after peeling the partition walls from the base material, the peeled partition walls may be placed on a substrate and used. As a method of peeling partition walls from a base material, a known method such as a method of providing a peeling auxiliary layer between the base material and the partition walls can be used.

### <Reflective layer formation step>

When a metal reflective layer and an inorganic protective layer and/or an organic protective layer are provided on the surface of the partition walls, examples of methods for forming these include methods exemplified as these formation steps in WO 2019/181444 and WO 2021/200327.

### <Filling step>

Examples of methods for filling the phosphor include methods exemplified as these filling steps in WO 2019/181444 and WO 2021/200327.

### <Semiconductor device>

The semiconductor device of the present invention has a semiconductor element and an insulating film made of the aforementioned cured product of the present invention. Examples of the semiconductor device include electro-optical devices and semiconductor circuit boards in which semiconductor elements are connected to substrates, electronic devices including these, and electronic components such as multilayer wiring boards for connecting semiconductor elements. Examples of the insulating film include interlayer insulating films of inductors, passivation films of semiconductors, surface protective films of semiconductor elements, interlayer insulating films between semiconductor elements/wiring, between multiple semiconductor elements, or between wiring layers of multilayer wiring for high-density mounting, insulating films of organic electroluminescent devices, and the like. By having a high aspect ratio insulating film made of the cured product of the present invention, the wiring density can be improved.

The thickness of the insulating film is preferably 100 µm or more from the viewpoint of further improving the wiring density, and preferably 1,000 µm or less from the viewpoint of suppressing warpage of the semiconductor device caused by film stress.

The aspect ratio of the insulating film can be calculated by H / {(L0 + L100) / 2} using the top width L0 (µm) of the high transmittance side surface, the bottom width L100 (µm) of the low transmittance side surface, and the height H (µm). The aspect ratio of the insulating film is preferably 16 or more, and more preferably larger than 16.0. The aspect ratio is preferably 30 or less, and more preferably 30.0 or less.

Since the cured product of the present invention can easily form a high aspect ratio pattern, it is preferably used for an inductor, which is a semiconductor device required to have a high aspect ratio insulating film.

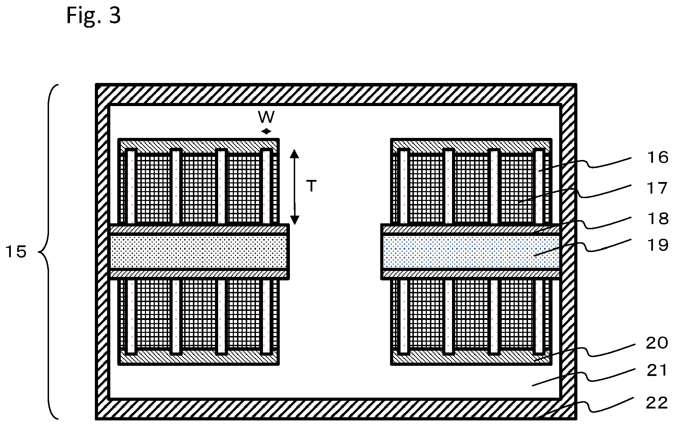

FIG. 3 shows a cross-sectional view schematically showing the configuration of an inductor, which is one embodiment of the semiconductor device of the present invention. The inductor 15 has coils 17 and insulating films 16 for maintaining insulation between the coils 17, via resin layers 18 above and below a substrate 19. Furthermore, the inductor 15 has a magnetic material 21 via an insulating film 20 and is sealed with a mold resin 22.

By using the aforementioned cured product of the present invention as the insulating film of the inductor, an insulating film exhibiting sufficient insulation even when the pattern width is small can be formed. Therefore, the cross-sectional area of the coil wiring can be increased, and the inductance of the inductor can be increased.

### EXAMPLES

Hereinafter, the present invention will be described in more detail by giving examples and comparative examples. The compounds used in each example and comparative example were synthesized by the following method.

### <Synthesis Example 1: Synthesis of Polyimide A-1>

Under a dry nitrogen gas flow, 29.30 g (0.08 mol) of 2,2-bis(3-amino-4-hydroxyphenyl)hexafluoropropane (hereinafter abbreviated as "BAHF") (manufactured by Tokyo Chemical Industry Co., Ltd.) was added to 80 g of gamma-butyrolactone (hereinafter abbreviated as "GBL") (manufactured by Fujifilm Wako Pure Chemical Corporation), and the mixture was stirred and dissolved at 120°C. Next, 30.03 g (0.1 mol) of an acid anhydride "Rikacid" (registered trademark) TDA-100 (hereinafter abbreviated as "TDA-100") (manufactured by New Japan Chemical Co., Ltd.) was added together with 20 g of GBL, and the mixture was stirred at 120°C for 1 hour and then stirred at 200°C for 4 hours to obtain a reaction solution. Next, the reaction solution was poured into 3 L of water to precipitate a white precipitate. This precipitate was collected by filtration, washed three times with water, and then dried in a vacuum dryer at 80°C for 5 hours to obtain polyimide A-1 having a weight average molecular weight of 4,000 and a basic functional group equivalent of 1,000 g/eq or more.

### <Synthesis Example 2: Synthesis of Polyimide A-2>

Under a dry nitrogen gas flow, 32.96 g (0.09 mol) of BAHF was added to 80 g of GBL, and the mixture was stirred and dissolved at 120°C. Next, 30.03 g (0.1 mol) of TDA-100 was added together with 20 g of GBL, and the mixture was stirred at 120°C for 1 hour and then stirred at 200°C for 4 hours to obtain a reaction solution. Next, the reaction solution was poured into 3 L of water to precipitate a white precipitate. This precipitate was collected by filtration, washed three times with water, and then dried in a vacuum dryer at 80°C for 5 hours to obtain polyimide A-2 having a weight average molecular weight of 8,000 and a basic functional group equivalent of 1,000 g/eq or more.

### <Synthesis Example 3: Synthesis of Polyamideimide A-3>

BAHF (18.3 g, 0.05 mol) (manufactured by Tokyo Chemical Industry Co., Ltd.) was dissolved in 100 mL of acetone (manufactured by Tokyo Chemical Industry Co., Ltd.) and propylene oxide (17.4 g, 0.3 mol) (manufactured by Fujifilm Wako Pure Chemical Corporation) and cooled to -15°C. A solution prepared by dissolving 3-nitrobenzoyl chloride (20.4 g, 0.11 mol) (manufactured by Tokyo Chemical Industry Co., Ltd.) in 100 mL of acetone (manufactured by Tokyo Chemical Industry Co., Ltd.) was added dropwise thereto. After the dropwise addition was completed, the mixture was reacted by stirring at -15°C for 4 hours, and then the reaction solution was returned to room temperature. The precipitated white solid was filtered off and vacuum-dried at 50°C.

30 g of the obtained white solid was placed in a 300 mL stainless steel autoclave, dispersed in 250 mL of methyl cellosolve (manufactured by Tokyo Chemical Industry Co., Ltd.), and 2 g of 5% by mass palladium-carbon was added. Hydrogen was introduced thereto using a balloon, and the mixture was stirred at room temperature to perform a reduction reaction. After about 2 hours, it was confirmed that the balloon did not deflate any further, and stirring was stopped. After the completion of stirring, the palladium compound as a catalyst was removed by filtration, and the filtrate was concentrated with a rotary evaporator to obtain a hydroxyl group-containing diamine compound (a).

Under a dry nitrogen gas flow, 31.4 g (0.08 mol) of the hydroxyl group-containing diamine compound (a) was added to 80 g of GBL (manufactured by Fujifilm Wako Pure Chemical Corporation), and the mixture was stirred at 120°C. Next, 30.0 g (0.1 mol) of TDA-100 (manufactured by New Japan Chemical Co., Ltd.) was added together with 20 g of GBL, and the mixture was stirred at 120°C for 1 hour and then stirred at 200°C for 4 hours to obtain a reaction solution. Next, the reaction solution was poured into 3 L of water to precipitate a white precipitate. This precipitate was collected by filtration, washed three times with water, and then dried in a vacuum dryer at 80°C for 5 hours to obtain polyamideimide A-3 having a weight average molecular weight of 5,000 and a basic functional group equivalent of 1,000 g/eq or more.

Other raw materials used in the examples and comparative examples are shown below.
(A) Resin
   A-4: "Maruka Linker" (registered trademark) M (manufactured by Maruzen Petrochemical Co., Ltd.), poly-p-hydroxystyrene, a resin having a weight average molecular weight of 4,000 and a basic functional group equivalent of 1,000 g/eq or more
(B) Epoxy compound or oxetane compound
   B-1: OXT-191 (manufactured by Toagosei Co., Ltd.), a water-insoluble compound having an average of 12 oxetanyl groups, having a structure represented by the general formula (1), where R¹ is polysilicate and R² is an ethyl group, and not having a polyalkylene glycol chain
   B-2: OXT-121 (manufactured by Toagosei Co., Ltd.), a bifunctional oxetane compound not having a polyalkylene glycol chain: water-insoluble compound
   B-3: "DENACOL" (registered trademark) EX-861 (manufactured by Nagase ChemteX Corporation), a bifunctional epoxy compound having a polyethylene glycol chain: water-soluble compound
   B-4: "TEPIC" (registered trademark)-VL (manufactured by Nissan Chemical Corporation), a trifunctional epoxy compound not having a polyalkylene glycol chain: water-insoluble compound
(C) Photocationic polymerization initiator
   C-1: CPI-410S (manufactured by San-Apro Ltd.), aromatic sulfonium phosphate salt.
   C-2: CPI-410B (manufactured by San-Apro Ltd.), aromatic sulfonium borate salt.

Next, evaluation methods in each example and comparative example will be described.

### <Transmittance>

Regarding a coating film of the photosensitive polyimide varnish prepared in each example and comparative example, three randomly selected locations were cut in a direction perpendicular to the surface with a width of 20 µm to cut out samples with a thickness of 20 µm. For the samples, the transmittance in the thickness direction was measured using a microspectrophotometer at a position 10 µm from one surface and at a position 10 µm from the other surface of the coating film of the varnish, and the average value of the values at the three locations was calculated. The one with the higher transmittance value was designated as Tα, and the one with the lower value was designated as Tβ.

Regarding the lattice-shaped partition walls formed in each example and comparative example, the transmittance was similarly measured at three randomly selected locations, and the average value thereof was calculated, where the higher transmittance value was designated as T'α and the lower value was designated as T'β.

### <Content of (C) Photocationic Polymerization Initiator>

Regarding the coating film of the photosensitive polyimide varnish prepared in each example and comparative example, the surfaces on the high transmittance side and the low transmittance side were each shaved with a file to a depth of 10%, and 100 mg of each part near the depth of 10% from the high transmittance side surface and near the depth of 90% was collected and used as a measurement sample. After adding 0.5 mL of acetonitrile to 10 mg of each measurement sample, ultrasonic treatment was performed for 60 minutes, and centrifugation was performed at 20,000 g for 15 minutes. A part of the supernatant after centrifugation was transferred to a brown measurement vial, the peak of an anionic component derived from the (C) photocationic polymerization initiator was quantitatively analyzed by HPLC, the content of the (C) photocationic polymerization initiator was calculated, and the content C10 (% by mass) of the (C) photocationic polymerization initiator at a depth of 10% from the surface on the side where the transmittance is Tα (%) and the content C90 (% by mass) of the (C) photocationic polymerization initiator at a depth of 90% from the surface were determined.

### <Height H', Top Width L'0, Bottom Width L'100, L'n, L'0/L'100 of Partition Wall, Maximum Rate of Change in Width, Aspect Ratio>

Regarding the lattice-shaped partition walls formed in each example and comparative example, at three randomly selected locations, a cross-section perpendicular to the substrate and perpendicular to the long side direction was cut, or a cross-section exposed by a polishing device such as a cross section polisher was observed using a scanning electron microscope, and the width of the topmost part of the partition wall, the width of the partition wall at a contact portion between the partition wall and the substrate, and the height of the partition wall were measured, and the average values thereof were calculated as L'0, L'100, and H', respectively. From these measurement values, L'0/L'100 and the aspect ratio (H'/((L'0 + L'100)/2)) were calculated. Further, the partition wall width Ln at a depth of n% with respect to the height H' of the partition wall from the topmost part of the partition wall was measured for every 1% of the depth, and the maximum rate of change in width (the maximum value of {L'(n+1) - L'n}/(L'100 - L'0)) was calculated. However, the partition wall width L'n was the average value of measurement values at the three locations.

### <Example 1>

### <Preparation of Photosensitive Polyimide Varnish>

10 g of polyimide A-1 obtained in Synthesis Example 1 as the (A) resin, 10 g of B-1, 1.0 g of B-2, and 1.0 g of B-3 as the (B) epoxy compound and/or oxetane compound, and 0.066 g of C-1 as the (C) photocationic polymerization initiator were weighed and dissolved in GBL. The addition amount of GBL was adjusted so that components other than GBL were solid content and the solid content concentration was 60 % by mass. Thereafter, the solution was pressure-filtered using a filter having a retained particle size of 30 µm to obtain photosensitive polyimide varnish 1 for the high transmittance side.

10 g of polyimide A-1 obtained in Synthesis Example 1 as the (A) resin, 10 g of B-1, 1.0 g of B-2, and 1.0 g of B-3 as the (B) epoxy compound and/or oxetane compound, and 0.22 g of C-1 as the (C) photocationic polymerization initiator were weighed and dissolved in GBL. The addition amount of GBL was adjusted so that components other than GBL were solid content and the solid content concentration was 70 % by mass. Thereafter, the solution was pressure-filtered using a filter having a retained particle size of 30 µm to obtain photosensitive polyimide varnish 2 for the low transmittance side.

### <Preparation of Scintillator Panel>

### <Formation of Partition Walls>

As a substrate, a PET film of 125 mm length × 125 mm width × 0.25 mm thickness was used. On the surface of the substrate, the photosensitive polyimide varnish 2 was applied using a die coater so that the thickness after thermal crosslinking curing was 70 µm, and dried using a hot air oven at 110°C for 1 hour to form a coating film of the photosensitive polyimide varnish 2. Next, on the coating film of the photosensitive polyimide varnish 2, the photosensitive polyimide varnish 1 was applied using a die coater so that the thickness after thermal crosslinking curing was 280 µm, and dried using a hot air oven at 110°C for 3 hours to form a coating film of the photosensitive polyimide varnish 1.

Next, the laminate of the coating films of the photosensitive polyimide varnishes was exposed at an exposure amount of 5000 mJ/cm² using an ultra-high pressure mercury lamp and a bandpass filter that cuts light of wavelengths other than 405 nm through a chrome mask having lattice-shaped openings with a pitch of 200 µm and line widths of 12 µm, 15 µm, and 20 µm. After the exposure, post-exposure heating was performed at 100°C for 90 minutes using a hot air oven. The coating film after the exposure and heating was developed in a 0.5% by mass potassium hydroxide aqueous solution at 30°C until the unexposed areas were removed, to obtain a lattice-shaped pattern. The obtained lattice-shaped pattern was heated in air at 200°C for 60 minutes to perform thermal crosslinking curing, thereby forming lattice-shaped partition walls.

### <Formation of Metal Reflective Layer and Inorganic Protective Layer>

Regarding the formed lattice-shaped partition walls, sputtering was performed using a silver alloy APC (manufactured by Furuya Metal Co., Ltd.), which is an alloy containing silver, palladium, and copper, as a sputter target using a commercially available sputtering apparatus to form a metal reflective layer. The sputtering was performed under the condition that a glass flat plate was placed in the vicinity of the substrate on which the partition walls were formed, and the thickness of the metal layer formed on the glass flat plate was 300 nm. After forming the metal reflective layer, SiN was sputtered as an inorganic protective layer in the same vacuum batch to form an inorganic protective layer. At this time, it was performed under the condition that the thickness of the inorganic protective layer formed on the glass substrate was 100 nm.

### <Formation of Organic Protective Layer>

1 part by mass of a fluorine-based solvent CT-SOLV180 (manufactured by AGC Inc.) was mixed with 1 part by mass of an amorphous fluorine-containing resin "CYTOP" (registered trademark) CTL-809M to prepare a resin solution.

The obtained resin solution was vacuum-printed on the partition walls on which the metal reflective layer and the inorganic protective layer had been formed, dried at 90°C for 1 hour, and further heated at 190°C for 1 hour to form an organic protective layer. The cross-section of the partition wall was exposed using a triple ion milling apparatus EMTIC3X (manufactured by LEICA), the cross-section of the partition wall was imaged using a field emission scanning electron microscope (FE-SEM) Merlin (manufactured by Zeiss), and the thickness of the organic protective layer was measured; the thickness of the organic protective layer at the side surface of the central part in the height direction of the partition wall was 1 µm.

### <Formation of Phosphor Layer>

10 parts by mass of a phosphor GOS:Tb (gadolinium oxysulfide doped with Tb) was mixed with 5 parts by mass of a 10% by mass binder resin solution in which a binder resin "ETHOCEL" (registered trademark) 7cp (manufactured by The Dow Chemical Company) was dissolved in benzyl alcohol (manufactured by Fujifilm Wako Pure Chemical Corporation) to prepare a phosphor paste. The average particle diameter D50 of the phosphor measured using a particle size distribution measuring device MT3300 (manufactured by Nikkiso Co., Ltd.) was 11 µm.

In the cells partitioned by the partition walls on which the metal reflective layer, the inorganic protective layer, and the organic protective layer were formed as described above, the obtained phosphor paste was vacuum-printed so that the volume fraction of the phosphor was 65%, and dried at 150°C for 15 minutes to form a phosphor layer, thereby obtaining a scintillator panel.

### <Examples 2 to 9, Comparative Examples 1 to 2>

Partition walls and scintillator panels were prepared in the same manner as in Example 1 except that the types and addition amounts (parts by mass) of the (A) resin, (B) oxetane compound and/or epoxy compound, and (C) photocationic polymerization initiator were changed as shown in Table 1.

### <Example 10>

Partition walls and scintillator panels were prepared in the same manner as in Example 1 except that the drying time of the photosensitive polyimide varnish 1 was changed to 2 hours.

### <Example 11>

Partition walls and scintillator panels were prepared in the same manner as in Example 1 except that the drying time of the photosensitive polyimide varnish 1 was changed to 1 hour.

### <Example 12>

On a PET film with a thickness of 50 µm, the photosensitive polyimide varnish 1 was applied using a die coater so that the thickness after thermal crosslinking curing was 280 µm, and dried at 110°C for 3 hours to form a coating film of the photosensitive polyimide varnish 1. Also, on the surface of a glass substrate, the photosensitive polyimide varnish 2 was applied using a die coater so that the thickness after thermal crosslinking curing was 70 µm, and dried using a hot air oven at 110°C for 1 hour to form a coating film of the photosensitive polyimide varnish 2. Both substrates on which the coating films of the photosensitive polyimide varnish were formed were laminated using a vacuum diaphragm laminator (manufactured by Meiki Co., Ltd., MVLP-500/600) with the coating films facing each other under conditions of upper and lower hot plate temperatures of 80°C, a vacuum time of 20 seconds, a vacuum press time of 30 seconds, and a bonding pressure of 0.5 MPa; thereafter, only the PET film was peeled off to form a resin composition film with a thickness of 350 µm on the glass substrate. Partition walls and scintillator panels were prepared in the same manner as in Example 1 except that the obtained resin composition film was used as the laminate of the coating films of the photosensitive polyimide varnish.

The results of evaluation by the aforementioned methods for each example and comparative example are shown in Tables 3 to 4.

**[Table 1-1]**

| | | | Example 1 | Example 2 | Example 3 | Example 4 | Example 5 | Example 6 |
|---|---|---|---|---|---|---|---|---|
| Composition of high transmittance side (parts by mass) | (A) Resin | A-1 | 100 | 100 | 100 | 100 | 100 | - |
| | | A-2 | - | - | - | - | - | 100 |
| | | A-3 | - | - | - | - | - | - |
| | | A-4 | - | - | - | - | - | - |
| | (B) Epoxy compound or oxetane compound | B-1 | 100 | 100 | 100 | 100 | 100 | 100 |
| | | B-2 | 10 | 10 | 10 | 10 | 10 | 10 |
| | | B-3 | 10 | 10 | 10 | 10 | 10 | 10 |
| | | B-4 | - | - | - | - | - | - |
| | (C) Photocationic polymerization initiator | C-1 | 0.66 | 0.68 | 0.66 | 0.44 | 1.10 | 0.66 |
| | | C-2 | - | - | - | - | - | - |
| Composition of low transmittance side (parts by mass) | (A) Resin | A-1 | 100 | 100 | 100 | 100 | 100 | - |
| | | A-2 | - | - | - | - | - | 100 |
| | | A-3 | - | - | - | - | - | - |
| | | A-4 | - | - | - | - | - | - |
| | (B) Epoxy compound or oxetane compound | B-1 | 100 | 100 | 100 | 100 | 100 | 100 |
| | | B-2 | 10 | 10 | 10 | 10 | 10 | 10 |
| | | B-3 | 10 | 10 | 10 | 10 | 10 | 10 |
| | | B-4 | - | - | - | - | - | - |
| | (C) Photocationic polymerization initiator | C-1 | 2.20 | 1.32 | 4.40 | 8.80 | 1.32 | 2.20 |
| | | C-2 | - | - | - | - | - | - |

**[Table 1-2]**

| | | | Example 7 | Example 8 | Example 9 | Comparative Example 1 | Comparative Example 2 |
|---|---|---|---|---|---|---|---|
| Composition of high transmittance side (parts by mass) | (A) Resin | A-1 | - | - | 100 | 100 | 100 |
| | | A-2 | - | - | - | - | - |
| | | A-3 | 100 | - | - | - | - |
| | | A-4 | - | 100 | - | - | - |
| | (B) Epoxy compound or oxetane compound | B-1 | 100 | 100 | 100 | 100 | - |
| | | B-2 | 10 | 10 | 10 | 10 | - |
| | | B-3 | 10 | 10 | - | 10 | - |
| | | B-4 | - | - | - | - | 100 |
| | (C) Photocationic polymerization initiator | C-1 | 0.66 | 0.66 | - | 1.32 | 1.32 |
| | | C-2 | - | - | 0.66 | - | - |
| Composition of low transmittance side (parts by mass) | (A) Resin | A-1 | - | - | 100 | 100 | 100 |
| | | A-2 | - | - | - | - | - |
| | | A-3 | 100 | - | - | - | - |
| | | A-4 | - | 100 | - | - | - |
| | (B) Epoxy compound or oxetane compound | B-1 | 100 | 100 | 100 | 100 | - |
| | | B-2 | 10 | 10 | 10 | 10 | - |
| | | B-3 | 10 | 10 | - | 10 | - |
| | | B-4 | - | - | - | - | 100 |
| | (C) Photocationic polymerization initiator | C-1 | 2.20 | 2.20 | - | 1.32 | 1.32 |
| | | C-2 | - | - | 2.20 | - | - |

**[Table 2]**

| | | | Example 10 | Example 11 | Example 12 |
|---|---|---|---|---|---|
| Composition of high transmittance side (parts by mass) | (A) Resin | A-1 | 100 | 100 | 100 |
| | | A-2 | - | - | - |
| | | A-3 | - | - | - |
| | | A-4 | - | - | - |
| | (B) Epoxy compound or oxetane compound | B-1 | 100 | 100 | 100 |
| | | B-2 | 10 | 10 | 10 |
| | | B-3 | 10 | 10 | 10 |
| | | B-4 | - | - | - |
| | (C) Photocationic polymerization initiator | C-1 | 0.66 | 0.66 | 0.66 |
| | | C-2 | - | - | - |
| Composition of low transmittance side (parts by mass) | (A) Resin | A-1 | 100 | 100 | 100 |
| | | A-2 | - | - | - |
| | | A-3 | - | - | - |
| | | A-4 | - | - | - |
| | (B) Epoxy compound or oxetane compound | B-1 | 100 | 100 | 100 |
| | | B-2 | 10 | 10 | 10 |
| | | B-3 | 10 | 10 | 10 |
| | | B-4 | - | - | - |
| | (C) Photocationic polymerization initiator | C-1 | 2.20 | 2.20 | 2.20 |
| | | C-2 | - | - | - |

**[Table 3]**

| | Example 1 | Example 2 | Example 3 | Example 4 | Example 5 | Example 6 | Example 7 | Example 8 | Example 9 | Comp. Example 1 | Comp. Example 2 |
|---|---|---|---|---|---|---|---|---|---|---|---|
| Tα | 95% | 95% | 95% | 97% | 92% | 95% | 95% | 96% | 96% | 91% | 91% |
| Tβ | 85% | 91% | 73% | 53% | 91% | 85% | 86% | 86% | 86% | 91% | 91% |
| Tα-Tβ | 10% | 4% | 22% | 44% | 1% | 10% | 9% | 10% | 10% | 0% | 0% |
| C10 (% by mass) | 0.32 | 0.33 | 0.32 | 0.29 | 0.38 | 0.32 | 0.32 | 0.32 | 0.32 | 0.41 | 0.41 |
| C90 (% by mass) | 0.53 | 0.41 | 0.81 | 1.39 | 0.41 | 0.53 | 0.53 | 0.53 | 0.53 | 0.41 | 0.41 |
| C10/C90 | 0.61 | 0.80 | 0.40 | 0.21 | 0.93 | 0.61 | 0.61 | 0.61 | 0.61 | 1.00 | 1.00 |
| T'α | 52% | 52% | 52% | 53% | 51% | 51% | 52% | 52% | 30% | 51% | 50% |
| T'β | 48% | 50% | 43% | 16% | 50% | 47% | 48% | 48% | 26% | 51% | 50% |
| T'α - T'*β* | 4% | 2% | 9% | 37% | 1% | 4% | 4% | 4% | 4% | 0% | 0% |
| H' (µm) | 350 | 350 | 350 | 350 | 350 | 350 | 350 | 350 | 350 | 350 | 350 |
| L'0 (µm) | 15 | 16 | 16 | 17 | 21 | 16 | 20 | 20 | 18 | 24 | 34 |
| L'100 (µm) | 18 | 19 | 20 | 23 | 22 | 19 | 22 | 23 | 22 | 22 | 31 |
| L'0/L'100 | 0.83 | 0.84 | 0.80 | 0.74 | 0.95 | 0.84 | 0.91 | 0.87 | 0.82 | 1.09 | 1.10 |
| Maximum rate of change in width | 0.021 | 0.017 | 0.033 | 0.031 | 0.014 | 0.021 | 0.021 | 0.021 | 0.021 | 0.013 | 0.013 |
| Aspect ratio | 21.2 | 20.0 | 19.4 | 17.5 | 16.3 | 20.0 | 16.7 | 16.3 | 17.5 | 15.2 | 10.8 |

**[Table 4]**

| | Example 1 | Example 2 | Example 3 |
|---|---|---|---|
| Tα | 95% | 95% | 95% |
| Tβ | 85% | 85% | 85% |
| Tα-Tβ | 10% | 10% | 10% |
| C10 (% by mass) | 0.32 | 0.32 | 0.32 |
| C90 (% by mass) | 0.53 | 0.53 | 0.53 |
| C10/C90 | 0.61 | 0.61 | 0.61 |
| Tα | 52% | 52% | 52% |
| Tβ | 48% | 48% | 48% |
| Tα-Tβ | 4% | 4% | 4% |
| H' (µm) | 350 | 350 | 350 |
| L'0 (µm) | 15 | 15 | 15 |
| L'100 (µm) | 18 | 18 | 18 |
| L'0/L'100 | 0.83 | 0.83 | 0.83 |
| Maximum rate of change in width | 0.043 | 0.064 | 0.12 |
| Aspect ratio | 21.2 | 21.2 | 21.2 |

### DESCRIPTION OF REFERENCE SIGNS

1 Radiation detector member
2 Scintillator panel
3 Output substrate
4 Substrate
5 Partition wall
6 Phosphor layer
7 Diaphragm layer
8 Photoelectric conversion layer
9 Output layer
10 Substrate
11 Metal reflective layer
12 Organic protective layer
13 Phosphor
14 Binder resin
15 Inductor
16 Insulating film
17 Coil
18 Resin layer
19 Substrate
20 Insulating film
21 Magnetic material
22 Mold resin
H' Height of partition wall
L'0 Top width of partition wall
L'100 Bottom width of partition wall
P Interval between adjacent partition walls

## Claims

1. A photosensitive resin composition film comprising (A) a resin, (B) an epoxy compound and/or an oxetane compound, and (C) a photocationic polymerization initiator, wherein:
a transmittance Tα (%) per unit film thickness at a wavelength of 405 nm of one surface and a transmittance Tβ (%) per unit film thickness at a wavelength of 405 nm of the other surface satisfy the following formula (1): $Tα > Tβ$ (1) and
a content C10 (% by mass) of said (C) photocationic polymerization initiator at a depth of 10%, relative to the thickness of said photosensitive resin composition film, from the surface on the side where the transmittance per unit film thickness at a wavelength of 405 nm is Tα (%), and a content C90 (% by mass) of said (C) photocationic polymerization initiator at a depth of 90% from said surface satisfy the following formula (2): $0.050 \leq C 10 / C 90 \leq 0.85$ (2)

2. The photosensitive resin composition film according to claim 1, comprising a first film consisting of a first photosensitive resin composition containing (A) a resin, (B) an epoxy compound and/or an oxetane compound, and (C) a photocationic polymerization initiator, and a second film consisting of a second photosensitive resin composition containing (A) a resin, (B) an epoxy compound and/or an oxetane compound, and (C) a photocationic polymerization initiator, wherein content of said (C) photocationic polymerization initiator in said first photosensitive resin composition and content of said (C) photocationic polymerization initiator in said second photosensitive resin composition are different.

3. The photosensitive resin composition film according to claim 1 or 2, wherein said resin (A) contains polyimide, polyamide, polyamideimide and/or polybenzoxazole.

4. A cured product obtained by curing a photosensitive resin composition containing (A) a resin, (B) an epoxy compound and/or an oxetane compound, and (C) a photocationic polymerization initiator, wherein:
a transmittance T'α (%) per unit thickness at a wavelength of 405 nm of one surface and a transmittance T'β (%) per unit thickness at a wavelength of 405 nm of the other surface satisfy the following formula (3): $T ′ α > T ′ β$ (3) and
a height H (µm) is 100 µm or more.

5. The cured product according to claim 4, wherein a width L0 (µm) of the surface on the side where the transmittance per unit thickness at a wavelength of 405 nm of said cured product is T'α (%) and a width L100 (µm) of the surface on the side where the transmittance per unit thickness at a wavelength of 405 nm is T'β (%) satisfy the following formula (4): $L 0 / L 100 \leq 0.90$ (4)

6. The cured product according to claim 4 or 5, wherein, when a width at a depth of n% relative to the height H (µm) of said cured product from the surface on the side where the transmittance per unit thickness at a wavelength of 405 nm of said cured product is T'α (%) is defined as Ln, the following formula (5) is satisfied in a range where n is 0 to 99%: $\left\{L\left(n+1\right)-Ln\right\} / \left(L100-L0\right) < 0.10$ (5)

7. The cured product according to any one of claims 4 to 6, wherein a width L0 (µm) of the surface on the side where the transmittance per unit thickness at a wavelength of 405 nm of said cured product is T'α (%), a width L00 (µm) on the side where the transmittance per unit thickness at a wavelength of 405 nm is T'β (%), and the height H (µm) satisfy the following formula (7): $H / \left\{\left(L0+L100\right)/2\right\} > 16.0$ (7)

8. The cured product according to any one of claims 4 to 7, wherein said resin (A) contains polyimide, polyamide, polyamideimide and/or polybenzoxazole.

9. A method of producing a photosensitive resin composition film according to any one of claims 1 to 3, comprising:
a step of forming a first film using a first photosensitive resin composition containing (A) a resin, (B) an epoxy compound and/or an oxetane compound, and (C) a photocationic polymerization initiator; and
a step of forming a second film on said first film using a second photosensitive resin composition containing (A) a resin, (B) an epoxy compound and/or an oxetane compound, and (C) a photocationic polymerization initiator,
wherein content of said (C) photocationic polymerization initiator in said first photosensitive resin composition and content of said (C) photocationic polymerization initiator in said second photosensitive resin composition are different.

10. A method of producing a cured product according to any one of claims 4 to 8, comprising:
an exposure step of imagewise exposing said photosensitive resin composition film according to any one of claims 1 to 3; and
a development step of removing unexposed portions using a developer.

11. A scintillator panel comprising a substrate, a partition wall formed on said substrate, and a phosphor layer filled in cells partitioned by said partition wall, wherein said partition wall consists of said cured product according to any one of claims 4 to 8.

12. A semiconductor device comprising a semiconductor element and an insulating film, wherein said insulating film consists of said cured product according to any one of claims 4 to 8.
